# EUROPÄISCHE PATENTSCHRIFT

(11) **EP 2 308 277 B1**
(45) Veröffentlichungstag und Bekanntmachung des Hinweises auf die Patenterteilung: **27.03.2019**
(21) Anmeldenummer: 09776557.2
(22) Anmeldetag: 23.04.2009
(51) Int. Cl.: H05K 5/02, H01R 13/46

(54) **GEHÄUSE FÜR EINE ANSCHLUSSEINHEIT**
HOUSING FOR A CONNECTING UNIT
BOÎTIER POUR UNE UNITÉ DE RACCORDEMENT

(30) Priorität: 29.07.2008 DE 102008035328
(43) Veröffentlichungstag der Anmeldung: 13.04.2011
(73) Patentinhaber: WABCO GmbH, 30453 Hannover (DE)
(72) Erfinder: HELLWIG, Simon, 30163 Hannover (DE); SCHUSCHAN, Christian, 30855 Langenhagen (DE); STEPHAN, Arne, 31319 Sehnde (DE)
(74) Vertreter: Lauerwald, Jörg
(86) Internationale Anmeldenummer: PCT/EP2009/002949
(87) Internationale Veröffentlichungsnummer: WO 2010/012324

(56) Entgegenhaltungen:
- EP-A- 1 464 880
- WO-A-2004/060723
- DE-A1- 10 243 313
- DE-U1- 29 704 288
- US-A1- 2007 238 352

## Beschreibung

Die Erfindung betrifft ein Gehäuse für eine Anschlusseinheit, insbesondere eine Elektronikeinheit, mit mindestens einem ersten Steckverbinder und einer ersten Steckachse des ersten Steckverbinders.

Bekannte Elektronikeinheiten weisen einen oder mehrere Steckverbinder auf, um die Elektronikeinheiten mit Sensoren, Aktuatoren und/oder Anzeigesystemen zu verbinden. Die Steckverbinder sind häufig nicht gekennzeichnet, so dass eine falsche Verbindung bei gleichartigen Steckverbindern an einer Elektronikeinheit nicht ausgeschlossen werden kann.

Der vorliegenden Erfindung liegt deshalb die Aufgabe zugrunde, ein Gehäuse für einen Elektronikeinheit zu schaffen, bei dem mit einfachen und kostengünstigen Mitteln die Verbindungsmöglichkeit des Steckverbinders mit dem richtigen Gegenstück eines Anschlussorgans vereinfacht und/oder verbessert wird.

Die Druckschrift DE29704288U1 betrifft ein Markierungsmittel zur Kennzeichnung der Anschlüsse elektrischer Steckverbinder und Buchsenleisten. Das Markierungsmittel kann als Codierstreifen kann mit den jeweiligen Anschlüssen an der Gehäuseseite oder der Oberseite des Steckverbinders benachbarten Kennzeichnungsstrichen oder Kennzeichnungspunkten mit unterschiedlichen Farben, Größen oder Positionen ausgebildet sein, wobei die Codierstreifen die jeweiligen Pins eines einzigen Steckverbinders kennzeichnen. Der Codierstreifen gibt somit einzig und allein einen Hinweis auf die Belegung der einzelnen Pins des einzigen Steckver-binders.

Die EP1464880A1 beschreibt eine pneumatische Ventileinheit, umfassend mehrere aneinandergereihte Mehrwegeventile, einen gemeinsamen inneren Speisekanal und einen gemeinsamen inneren Entlüftungskanal zur Zufuhr bzw. Abfuhr von Luft zu/von den Mehrwegeventilen, und eine Verbindungseinheit zur Verbindung der Mehrwegeventile mit elektrischen und/oder pneumatischen Quellen, wobei ein Beschriftungsfeld am Gehäuse der besagten Verbindungseinheit vorgesehen ist, welches zumindest eine als Buchstabe, Symbol und/oder Zeichen ausgebildete durchgehende Öffnung aufweist, wobei die besagte Öffnung mit dem mindestens einen inneren Entlüftungskanal zum Ableiten der Abluft an die Atmosphäre in Verbindung steht.

Die Aufgabe wird durch die Merkmale des Anspruchs 1 gelöst. Zur Lösung der Aufgabe weist das Gehäuse einen ersten Streifen auf, wobei eine erste Längsachse des ersten Streifens in einer räumlichen Ebene mit der ersten Steckachse des ersten Steckverbinders angeordnet ist. Der Vorteil der Erfindung ist darin zu sehen, dass ein einfaches Auffinden des "richtigen" Steckverbinders für das entsprechende Anschlussorgan, wie z.B. eine Datenbusverbindung, ein Sensor, ein Aktuator und/oder ein Anzeigesystem, durch den ersten Streifen wesentlich verbessert wird und die Ausrichtung oder Erstreckung des ersten Streifens die Bewegungsrichtung des mit dem Steckverbinder zu verbindenden Anschlussorgans angibt und damit eine korrekte Verbindung erleichtert wird bzw. gewährleistet ist.Der erste Streifen erleichtert die optische Wahrnehmung der Anordnung des Steckverbinders und leitet die Bedienperson, welche den Steckverbinder mit dem Anschlussorgan verbinden will, schnell und direkt zu dem "richtigen" Steckverbinder.

Ein weiterer Vorteil ist darin zu sehen, dass der erste Streifen kostengünstig in oder an der Oberfläche des Gehäuses der Elektronikeinheit angebracht wird. Insbesondere ist der erste Streifen in der Oberfläche des Gehäuses integriert und damit einstückig mit dem Gehäuse verbunden. Dadurch ist kein zusätzliches Bauteil für den ersten Streifen erforderlich. Gemäß einer Weiterbildung nach Anspruch 2 ist vorgesehen, dass das Gehäuse mindestens einen zweiten Steckverbinder mit einer zweiten Steckachse und einen zweiten Streifen aufweist, wobei eine zweite Längsachse des zweiten Streifens in einer räumlichen Ebene mit der zweiten Steckachse des zweiten Steckverbinders angeordnet ist. Der Vorteil dieser Weiterbildung ist darin zu sehen, dass die Bedienperson auch den zweiten Steckverbinder mit Hilfe des zweiten Streifens einfach, schnell und direkt auffinden und korrekt mit dem betreffenden Anschlussorgan verbinden kann. Ebenso vorteilhaft kann der zweite Streifen kostengünstig in oder an der Oberfläche des Gehäuses der Elektronikeinheit angebracht werden oder in der Oberfläche des Gehäuses integriert werden, so dass kein zusätzliches Bauteil für den zweiten Streifen erforderlich ist.

Gemäß einer Weiterbildung nach Anspruch 3 ist vorgesehen, dass das Gehäuse mindestens einen dritten Steckverbinder mit einer dritten Steckachse und einen dritten Streifen aufweist, wobei eine dritte Längsachse des dritten Streifens in einer räumlichen Ebene mit der dritten Steckachse des dritten Steckverbinders angeordnet ist. Der Vorteil dieser Weiterbildung ist darin zu sehen, dass die Bedienperson auch den dritten Steckverbinder mit Hilfe des dritten Streifens einfach, schnell und direkt auffinden und korrekt mit dem betreffenden Anschlussorgan verbinden kann. Ebenso vorteilhaft kann der dritte Streifen kostengünstig in oder an der Oberfläche des Gehäuses der Elektronikeinheit angebracht werden oder in der Oberfläche des Gehäuses integriert werden, so dass kein zusätzliches Bauteil für den dritten Streifen erforderlich ist.

Gemäß einer Weiterbildung nach Anspruch 4 ist vorgesehen, dass der zweite und/oder dritte Streifen eine andere Oberflächenbeschaffenheit aufweist, als die Gehäuseoberfläche. Der Vorteil dieser Weiterbildung ist darin zu sehen, dass die - insbesondere optische - Wahrnehmung des entsprechenden Streifens gegenüber der Gehäuseoberfläche der Elektronikeinheit erhöht wird. Die Oberflächenbeschaffenheit des Streifens oder der entsprechenden Streifen könnte in einer besonderen Ausgestaltung der Erfindung glatter als die Gehäuseoberfläche ausgeführt werden, was einem geringeren Rz bzw. Ra Wert des Streifens gegenüber dem Rz bzw. Ra Wert der Gehäuseoberfläche entsprechen würde. Andererseits ist es auch möglich, die Oberflächenbeschaffenheit des Streifens rauer als die Gehäuseoberfläche zu gestalten, was einem höheren Rz bzw. Ra Wert des Streifens gegenüber dem Rz bzw. Ra Wert der Gehäuseoberfläche entsprechen würde.

Gemäß einer Weiterbildung nach Anspruch 5 ist vorgesehen, dass der Streifen gegenüber der Gehäuseoberfläche vertieft angeordnet ist. Der Vorteil dieser Weiterbildung ist darin zu sehen, dass durch die vertiefte Anordnung des Streifens die optische Wahrnehmungsfähigkeit des Streifens gegenüber der übrigen Gehäuseoberfläche deutlich erhöht wird. Ein weiterer Vorteil der erfindungsgemäßen Weiterbildung besteht darin, dass die Vertiefung des Streifens gegenüber der Gehäuseoberfläche auch eine fühlbare bzw. tastbare Wahrnehmung schafft. Dies kann an schwer zugänglichen Einbaustellen des Gehäuses in einem Fahrzeug die Verbindung des Steckverbinders mit einem Gegenstück des Anschlussorgans erleichtern und sicherer machen.

Gemäß einer Weiterbildung nach Anspruch 6 ist vorgesehen, dass der Streifen gegenüber der Gehäuseoberfläche erhöht angeordnet ist. Der Vorteil dieser Weiterbildung ist darin zu sehen, dass durch die Erhöhung des Streifens die optische Wahrnehmungsfähigkeit des Streifens gegenüber der übrigen Gehäuseoberfläche deutlich erhöht wird. Ein weiterer Vorteil der erfindungsgemäßen Weiterbildung besteht darin, dass die Erhöhung des Streifens gegenüber der Gehäuseoberfläche auch eine fühlbare bzw. tastbare Wahrnehmung schafft. Dies kann an schwer zugänglichen Einbaustellen des Gehäuses in einem Fahrzeug die Verbindung des Steckverbinders mit einem Gegenstück des Anschlussorgans erleichtern und sicherer machen.

Gemäß einer Weiterbildung nach Anspruch 7 ist vorgesehen, dass der erste, zweite und/oder dritte Streifen eine Beschriftung aufweist. Der Vorteil dieser Weiterbildung der Erfindung ist darin zu sehen, dass die Anordnung der Beschriftung in dem oder den entsprechenden Streifen die Auffindbarkeit und Sichtbarkeit der Beschriftung deutlich erhöht und hervorhebt. Die Beschriftung kann in besonders vorteilhafter weise die Bezeichnung der Funktion des entsprechenden Steckverbinders oder auch Angaben zu dem Hersteller beinhalten. Bei einer besonderen Ausführungsform der Erfindung kann für den ersten, zweiten und/oder dritten Steckverbinder ein identischer Steckverbinder, welcher kostengünstig als Massenprodukt herstellbar ist, eingesetzt werden, da eine falsche Verbindung des jeweiligen Steckverbinders durch den oder die Streifen und die Beschriftung in bzw. an den Streifen weitestgehend vermieden werden kann.

Bei der besonderen Ausführungsform eines vertieft angeordneten Streifens kann die Beschriftung gegenüber der Streifenoberfläche z.B. bis maximal zum Abschluss der Gehäuseoberfläche erhöht angeordnet werden. Dies erhöht die Sicht- und Fühlbarkeit und damit die Erkennung der Beschriftung und des Streifens und schützt die Beschriftung vor Abnutzung oder Beschädigung durch äußere Einwirkung.

Gemäß einer Weiterbildung nach Anspruch 8 ist vorgesehen, dass der erste, zweite und/oder dritte Streifen parallel zueinander angeordnet sind. Der Vorteil dieser Weiterbildung ist darin zu sehen, dass alle Gegenstücke der Anschlussorgane der entsprechenden Steckverbinder dieselbe Steckrichtung aufweisen und diese leicht erkennbar ist.

Gemäß einer Weiterbildung nach Anspruch 9 ist vorgesehen, dass der erste, zweite und/oder dritte Streifen senkrecht zu der ersten, zweiten und/oder dritten Steckachse angeordnet ist. Der Vorteil dieser Weiterbildung ist darin zu sehen, dass ein entsprechender Streifen auch auf der Gehäuseoberfläche angeordnet werden kann, zu der ein Steckverbinder mit seiner Steckachse senkrecht ausgerichtet ist.

Gemäß einer Weiterbildung nach Anspruch 10 ist vorgesehen, dass der zweite und/oder dritte Streifen vom zweiten und/oder dritten Steckverbinder beginnend bis zu einer Körperkante der Gehäuseoberfläche angeordnet ist. Der Vorteil dieser Weiterbildung ist darin zu sehen, dass der jeweilige Streifen die Länge des Gehäuses in seiner Erstreckung vollständig ausnutzt und sich von dem entsprechenden Steckverbinder bis zur Körperkante der Gehäuseoberfläche erstreckt, was die Erkennbarkeit des Streifens erhöht.

Gemäß einer Weiterbildung nach Anspruch 11 ist vorgesehen, dass die Breite (b1, b2, b3) des ersten, zweiten und/oder dritten Streifens maximal der Breite (B1, B2, B3) des ersten, zweiten und/oder dritten Steckverbinders entspricht. Der Vorteil dieser Weiterbildung ist darin zu sehen, dass von der Breite des Streifens auf die Breite des zugeordneten Steckverbinders geschlossen werden kann und umgekehrt, was die Erkennung des zugeordneten Steckverbinders durch den jeweiligen Streifen erleichtert.

Gemäß einer Weiterbildung nach Anspruch 12 ist vorgesehen, dass der erste, zweite und/oder dritte Streifen die gleiche Breite (b1, b2, b3) aufweisen. Der Vorteil dieser Weiterbildung ist darin zu sehen, dass Auffindbarkeit der Streifen erhöht wird. Die gleiche Breite der einzelnen Streifen kann auch auf die gleiche Funktion der dazugehörigen Steckverbinder hinweisen. Ein weiterer Vorteil besteht darin, dass kein Streifen gegenüber einem oder mehreren anderen Streifen in seiner Bedeutung durch eine andere Breite hervorgehoben, d.h. breiter, oder zurückgedrängt, d.h. schmaler, wird. Trotzdem ist eine leichte und schnelle Auffindbarkeit aller Steckverbinder mit einem zugeordneten Streifen sichergestellt, so dass kein Steckverbinder versehentlich vergessen wird zu kontaktieren.

Gemäß einer Weiterbildung nach Anspruch 13 ist vorgesehen, dass die Breite (b1, b2, b3) des ersten, zweiten und/oder dritten Streifens maximal der kleinsten Breite (B1, B2, B3) des ersten, zweiten und/oder dritten Steckverbinders entspricht. Der Vorteil dieser Weiterbildung ist darin zu sehen, dass zwischen den einzelnen Streifen ausreichend Gehäuseoberfläche verbleibt, was die Erkennbarkeit und Unterscheidbarkeit der einzelnen Streifen verbessert.

Gemäß einer Weiterbildung nach Anspruch 14 ist vorgesehen, dass der erste, zweite und/oder dritte Streifen senkrecht zu der Gehäuseseite mit der höheren Anzahl von Steckverbindern angeordnet ist. Der Vorteil dieser Weiterbildung ist darin zu sehen, dass der oder die Streifen von den Steckverbindern an der Gehäuseseite mit der höchsten Anzahl an Steckverbindern ausgehen, was eine höhere bzw. die höchstmögliche Anzahl von Streifen auf der Gehäuseoberfläche zulässt. Damit wird eine erhöhte Erkennbarkeit der Steckverbinder durch die zugeordneten Streifen ermöglicht.

Gemäß einer Weiterbildung nach Anspruch 15 ist vorgesehen, dass der erste, zweite und/oder dritte Streifen senkrecht zu der Gehäuseseite mit der größeren Breite (B1, B2, B3) der ersten, zweiten und/oder dritten Steckverbinder angeordnet ist. Der Vorteil der Weiterbildung ist darin zu sehen, dass die breiteren Steckverbinder eine größere Breite der zugeordneten Streifen zulassen, wobei ein breiterer Streifen besser erkennbar erscheint und die Beschriftung in einem breiteren Streifen besser angeordnet werden kann.

Gemäß einer Weiterbildung nach Anspruch 16 ist vorgesehen, dass der erste, zweite und/oder dritte Streifen parallel zu der längsten Gehäuseseite angeordnet ist. Der Vorteil dieser Weiterbildung ist darin zu sehen, dass der oder die jeweilige(n) Streifen ein möglichst große Länge aufweist, was die Erkennbarkeit erhöht und die Unterbringung einer Beschriftung innerhalb des Streifens erleichtert und verbessert.

Gemäß einer Weiterbildung nach Anspruch 17 ist vorgesehen, dass der erste Streifen asymmetrisch auf dem Gehäuse angeordnet ist. Häufig weisen Steckverbinder eine sehr große Breite auf, welche sich fast über die gesamte Gehäusebreite erstreckt. Der Vorteil dieser Weiterbildung ist darin zu sehen, dass der erste Streifen kleiner als die Breite des ersten Steckverbinders ist, wodurch der erste Streifen nur einen Teil der Gehäuseoberfläche einnimmt bzw. ausfüllt und sich damit deutlich von der Gehäuseoberfläche abgrenzt, was die Erkennbarkeit des ersten Streifens erhöht und verbessert.

Gemäß einer Weiterbildung nach Anspruch 18 ist vorgesehen, dass der erste Streifen einen Abstand d von den Körperkanten der Gehäuseoberfläche aufweist. Der Vorteil dieser Weiterbildung ist darin zu sehen, dass der erste Streifen einen definierten und gleich bleibenden Abstand von den Körperkanten des Gehäuses aufweist, was die Erkennbarkeit und Unterscheidungskraft des ersten Streifens gegenüber der Gehäuseoberfläche erhöht und verbessert.

Gemäß einer Weiterbildung nach Anspruch 19 ist vorgesehen, dass der Abstand d der Breite (b1) des ersten Streifens entspricht. Der Vorteil der Weiterbildung ist darin zu sehen, dass die Erkennbarkeit des Streifens auf der Gehäuseoberfläche durch diesen vorbestimmten Abstand verbessert wird.

Die Erfindung ist nicht auf den Einsatz von einem ersten, zweiten und/oder dritten Streifen auf der Gehäuseoberfläche einer Elektronikeinheit beschränkt, sondern gilt analog auch für einen möglichen vierten, fünften, sechsten, usw. Streifen bei einer entsprechenden Anzahl von Steckverbindern. Die erfindungsgemäßen Weiterbildungen gelten entsprechend auch für diese weiteren möglichen Streifen.

Weiterhin kann die Erfindung auch bei Gehäusen für Pneumatikeinheiten, wie z.B. Bremsventile oder Bremsmodulatoren, eingesetzt werden. Dabei sind die Stecker als pneumatische Steckverbinder ausgeführt, wobei der jeweilige Streifen den jeweiligen pneumatischen Steckverbinder und dessen Steckrichtung kennzeichnet. Ansonsten sind die Ausführungen und Varianten der erfindungsgemäßen Streifen analog auf eine als Pneumatikeinheit ausgeführte Anschlusseinheit mit einem entsprechend ausgebildeten Gehäuse übertragbar.

Ausführungsbeispiele und weitere Vorteile der Erfindung werden im Zusammenhang mit den nachstehenden Figuren erläutert, darin zeigen:
Fig.1 - Gehäusedraufsicht mit drei Streifen,
Fig.2a - Gehäuse-Schnittdarstellung,
Fig.2b - Gehäuse-Schnittdarstellung,
Fig.3 - Gehäuse mit einem Streifen,
Fig.4 - Gehäuseseitenansicht mit einem Streifen,
Fig.5 - Gehäusedraufsicht mit zwei Streifen und zwei Steckverbindern,
Fig.6 - Gehäusedraufsicht mit zwei Streifen und vier Steckverbindern,
Fig.7 - Gehäusedraufsicht mit zwei Streifen und drei Steckverbindern,
Fig.8 - Gehäusedraufsicht mit zwei Streifen und zwei breiten Steckverbindern und zwei schmalen Steckverbindern.

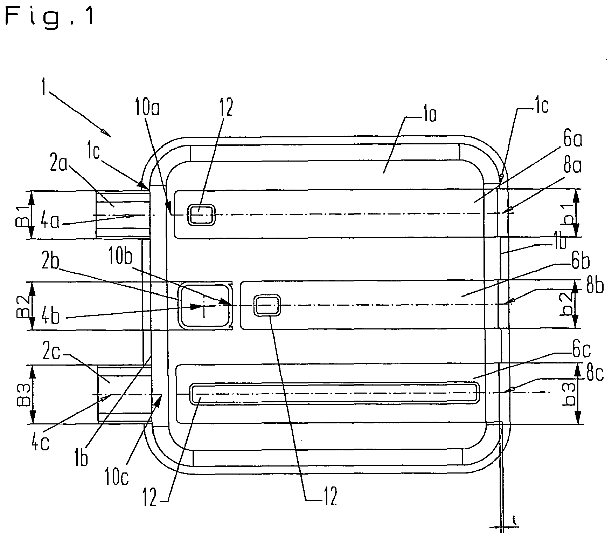

Die Fig.1 zeigt ein Gehäuse (1) für eine Anschlusseinheit. Die Anschlusseinheit kann als Elektronikeinheit oder als Pneumatikeinheit ausgebildet sein. Das Gehäuse (1) weist einen ersten Steckverbinder (2a) mit einer ersten Steckachse (4a), einen zweiten Steckverbinder (2b) mit einer zweiten Steckachse (4b) und einen dritten Steckverbinder (2c) mit einer dritten Steckachse (4c) auf. Der zweite Steckverbinder (2b) bzw. die zweite Steckachse (4b) ist in diesem Ausführungsbeispiel senkrecht zu dem ersten Steckverbinder (2a) bzw. der ersten Steckachse (4a) und senkrecht zu dem dritten Steckverbinder (2c) bzw. der dritten Steckachse (4c) und senkrecht zu der Gehäuseoberfläche (1a) angeordnet.
Parallel zur ersten Steckachse (4a) ist eine erste Längsachse (8a) eines ersten Streifens (6a) angeordnet, wobei diese einen nicht gezeigten, vorbestimmten Abstand zueinander aufweisen, so dass die erste Steckachse (4a) und die erste Längsachse (8a) eine erste räumliche Ebene (10a) bilden.

Die erste Längsachse (8a) bildet die Mittelachse des ersten Streifens (6a), welcher im Bereich der Gehäuseoberfläche (1a) angeordnet ist und an der Gehäuseseite (1c) teilweise weitergeführt wird. Der erste Streifen (6a) ist ausgehend von der Gehäuseseite (1c) an dem Stecker (2a) in Richtung der ersten Längsachse (8a) bis zur Körperkante (1b) bzw. der Gehäuseseite (1c) der gegenüberliegenden Gehäuseseite (1c) angeordnet. Der erste Streifen (6a) weist eine Beschriftung (12) bzw. ein Feld für eine Beschriftung (12) auf. Die Beschriftung (12) kann in einem Teil des ersten Streifens (6a) angeordnet sein oder über die gesamte Länge des ersten Streifens (6a) ausgebildet sein. Die Körperkante (1b) wird gebildet von der Schnittgeraden der Ebene der Gehäuseoberfläche (1a) und der Ebene der Gehäuseseite (1c), wobei die Körperkante (1b) einen Rundungsradius aufweisen kann. Der erste Streifen (6a) weist eine Breite (b1) auf, welche kleiner oder gleich der Breite (B1) des ersten Steckverbinders (2a) ist.

Die zweite Steckachse (4b), welche die Mittelachse des zweiten Steckers (2b) bildet, ist senkrecht zu der zweiten Längsachse (8b) des zweiten Streifens (6b) ausgerichtet, so dass von diesen beiden Achsen (4b, 8b) eine zweite räumliche Ebene (10b) gebildet wird. Auch der zweite Streifen (6b) weist eine Beschriftung (12) auf. Der zweite Streifen (6b) ist ausgehend von dem zweiten Steckverbinder (2b), welcher auf der Gehäuseoberfläche (1a) angeordnet ist, bis zu der einen Körperkante (1b) des Gehäuses (1) ausgebildet, und teilweise an der Gehäuseseite (1c) weitergeführt. Die Breite (b2) des zweiten Streifens (6b) ist kleiner oder gleich der Breite (B2) des zweiten Steckverbinders (2b).

Der dritte Steckverbinder (2c) ist an der gleichen Gehäuseseite (1c) wie der erste Steckverbinder (2a) angeordnet. Die dritte Steckachse (4c) des dritten Steckverbinders (2c) ist parallel zu der ersten Steckachse (4a) des ersten Steckverbinders (2a) angeordnet. Ebenso ist die dritte Steckachse (4c) parallel zu der dritten Längsachse (8c) des dritten Streifens (6c) angeordnet, wobei auch hier ein vorbestimmter Abstand zwischen den beiden Achsen (4c und 8c) vorhanden ist, so dass die dritte Steckachse (4c) und die dritte Längsachse (8c) eine dritte räumliche Ebene (10c) bilden. Die Beschriftung (12) innerhalb des dritten Streifens (6c) weist auf der Gehäuseoberfläche (1a) in etwa die gleiche Länge auf wie der dritte Streifen (6c).

Sowohl der erste Streifen (6a), der zweite Streifen (6b) als auch der dritte Streifen (6c) sind gegenüber der Gehäuseoberfläche (1a) um die Tiefe (t) vertieft angeordnet. Ebenso ist die Fortführung des ersten Streifens (6a), des zweiten Streifens (6b) und des dritten Streifens (6c) an der Gehäuseseite (1c) um die Tiefe (t) vertieft gegenüber der Oberfläche der Gehäuseseite (1c) angeordnet. Selbstverständlich ist es auch möglich, den ersten Streifen (6a), den zweiten Streifen (6b) und/oder den dritten Streifen (6c) jeweils mit einer unterschiedlichen Tiefe (t) gegenüber der Gehäuseoberfläche (1a) bzw. der Oberfläche der Gehäuseseite (1c) anzuordnen oder die Tiefe (t) auf den Wert Null zu reduzieren. Vorzugsweise weist die Oberflächenbeschaffenheit des ersten Streifens (6a), des zweiten Streifens (6b) und/oder des dritten Streifens (6c) eine andere Oberflächenbeschaffenheit, insbesondere eine höhere oder niedrigere Rauigkeit, auf als die Gehäuseoberfläche (1a) und/oder die Oberfläche der Gehäuseseite (1c) auf.

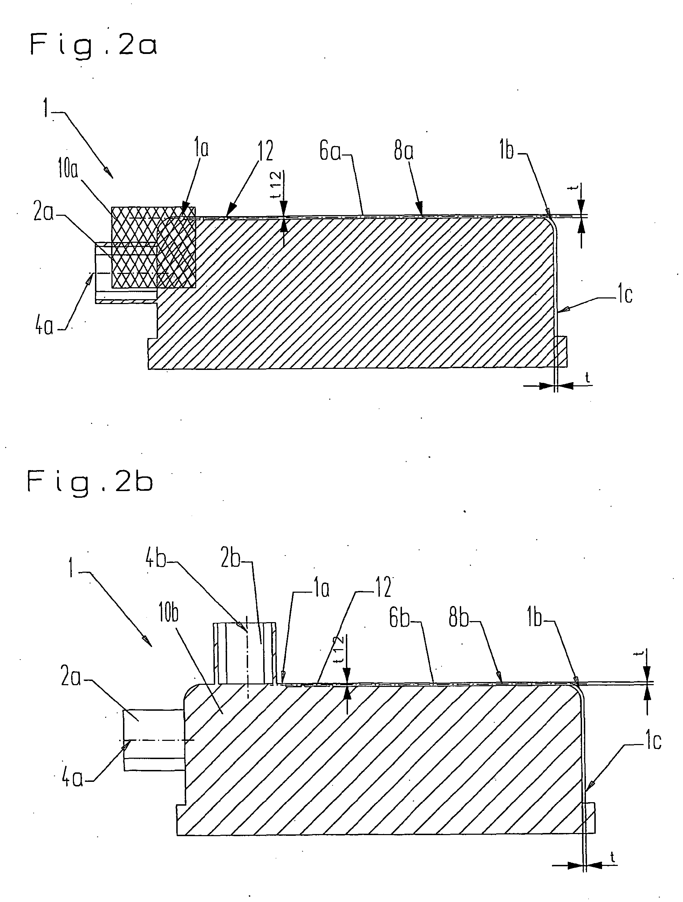

Die Figur 2a zeigt eine Schnittdarstellung durch das Gehäuse (1) der Figur 1 im Bereich der ersten räumlichen Ebene (10a). Hierbei ist deutlich zu erkennen, dass die erste Steckachse (4a) und die erste Längsachse (8a) einen vorbestimmten Höhenunterschied bzw. Abstand zueinander aufweisen und parallel zueinander angeordnet sind. Der erste Streifen (6a) ist um die Tiefe (t) vertieft gegenüber der Gehäuseoberfläche (1a) des Gehäuses (1) angeordnet. Die Beschriftung (12) innerhalb des ersten Streifens (6a) ist um die Beschriftungstiefe (t12) vertieft gegenüber der Gehäuseoberfläche (1a) angeordnet, um die Beschriftung besser vor Beschädigungen oder dergleichen zu schützen. Ein Teil des ersten Streifens (6a) ist über die Körperkante (1b) an der Gehäuseseite (1c) weitergeführt. Auch an der Gehäuseseite (1c) weist der erste Streifen (6a) eine Tiefe (t) gegenüber der Oberfläche der Gehäuseseite (1c) auf. Es ist auch möglich die Beschriftung (12) im Bereich des ersten Streifens (6a) an der Gehäuseseite (1c) anzuordnen.

Die Figur 2b zeigt eine Schnittdarstellung durch das Gehäuse (1) der Figur 1 entlang der zweiten räumlichen Ebene (10b). Die zweite Längsachse (8b) des zweiten Streifens (6b) ist senkrecht zu der zweiten Steckachse (4b) des zweiten Steckverbinders (2b) ausgerichtet, so dass diese beiden Achsen (4b, 8b) eine zweite räumliche Ebene (10b) bilden. Der zweite Streifen (6b) ist um die Tiefe (t) gegenüber der Gehäuseoberfläche (1a) des Gehäuses (1) vertieft angeordnet. Auch in diesem Fall wird ein Teil des zweiten Streifens (6b) über die Körperkante (1b) entlang der Gehäuseseite (1c) weitergeführt, wobei der zweite Streifen (6b) im Bereich der Gehäuseseite (1c) auch um die Tiefe (t) vertieft gegenüber der Oberfläche der Gehäuseseite (1c) angeordnet ist. Die Beschriftung (12) füllt nur einen Teil der Oberfläche des zweiten Streifens (6b) aus und ist um die Tiefe (t12) gegenüber der Gehäuseoberfläche (1a) vertieft angeordnet.

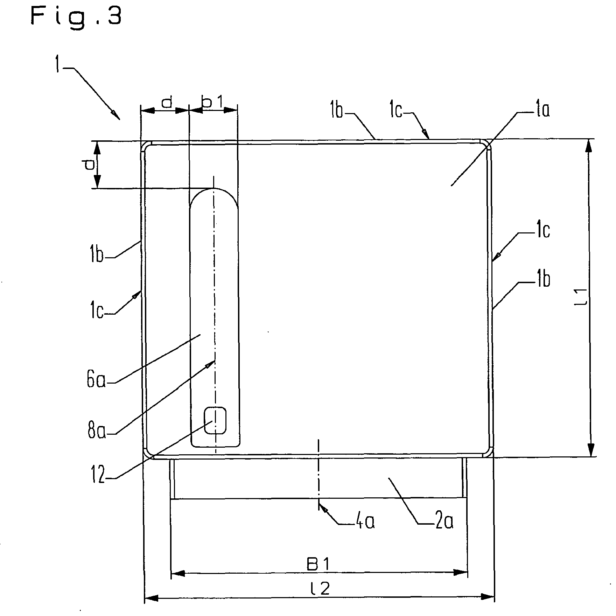

Die Figur 3 zeigt ein Gehäuse (1) in einer Draufsicht mit einem ersten Streifen (6a) und einem ersten Steckverbinder (2a). Die erste Steckachse (4a) des ersten Steckverbinders (2a) ist in einem vorbestimmten Abstand parallel zu der ersten Längsachse (8a) des ersten Streifens (6a) ausgerichtet, so dass diese beiden Achsen (4a, 8a) eine erste räumliche Ebene (10a) bilden. Das Gehäuse (1) weist eine erste Seitenlänge (I1) und eine zweite Seitenlänge (I2) auf, welche in diesem Fall eine identische Länge aufweisen. Der erste Steckverbinder (2a) weist eine Breite (B1) auf, welche fast der Seitenlänge (L2) entspricht. Die Breite (b1) des ersten Streifens (6a) ist wesentlich geringer als die Breite (B1) des ersten Steckverbinders (2a). Der erste Streifen (6a) ist ausgehend von der Körperkante (1b) bzw. der Gehäuseseite (1c), an welcher der erste Steckverbinder (2a) angeordnet ist, bis zur gegenüberliegenden Gehäuseseite (1c) bzw. eine Abstand (d) von der gegenüberliegenden Gehäuseseite (1c) angeordnet. Ebenso ist der erste Streifen (6a) in einem Abstand (d) von der Gehäuseseite (1c) bzw. der Körperkante (1b) an der Längsseite des ersten Streifens (6a) angeordnet. Vorzugsweise entspricht der Abstand (d) der Breite (b1) des ersten Streifens (6a). Der erste Streifen (6a) weist in der Nähe des ersten Steckverbinders (2a) eine Beschriftung (12) auf. Der erste Streifen (6a) kann gegenüber der Gehäuseoberfläche (1a) des Gehäuses (1) vertieft oder erhöht oder auf gleicher Höhe mit der Gehäuseoberfläche (1a) angeordnet sein. Vorteilhafterweise wird auch die Beschriftung (12) gegenüber der Oberfläche des Streifens (6a) und/oder der Gehäuseoberfläche (1a) vertieft angeordnet.

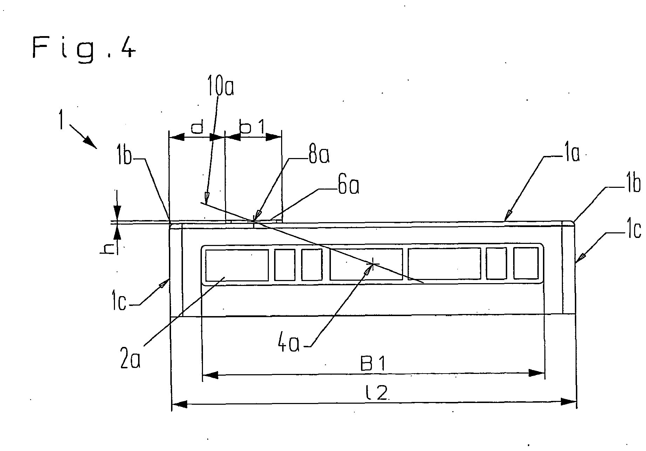

Die Figur 4 zeigt eine Seitenansicht des Gehäuses der Figur 3 mit Blickrichtung auf den ersten Steckverbinder (2a). Der erste Streifen (6a) ist gegenüber der Gehäuseoberfläche (1a) des Gehäuses (1) um die Höhe (h) im Abstand (d) von der linken Gehäuseseite (1c) angeordnet. Der Abstand (d) entspricht der Breite (b1) des ersten Streifens (6a). Die erste räumliche Ebene (10a) wird durch die in Blickrichtung verlaufende erste Längsachse (8a) des ersten Streifens (6a) und durch die in Blickrichtung verlaufende erste Steckachse (4a) des ersten Streifens (2a) gebildet. Die Breite (B1) des ersten Steckverbinders (2a) ist kleiner als die zweite Seitenlänge (I2) und größer als die Breite (b1) des ersten Streifens (6a).

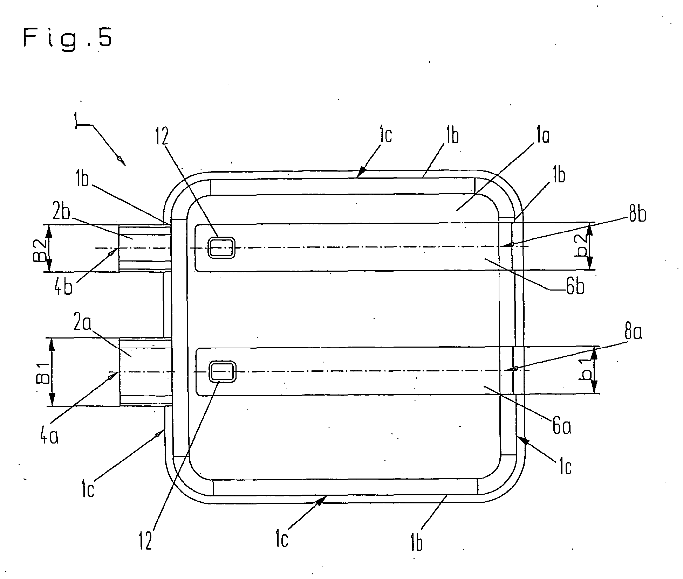

Die Figur 5 zeigt eine Draufsicht auf ein Gehäuse (1) mit einem ersten Steckverbinder (2a) und einem diesem ersten Steckverbinder (2a) zugeordneten ersten Streifen (6a) sowie einem zweiten Steckverbinder (2b) und einem diesem zweiten Steckverbinder (2b) zugeordneten zweiten Streifen (6b). Die erste Steckachse (4a) des ersten Steckverbinders (2a) verläuft in einem vorbestimmten Abstand parallel zu der ersten Längsachse (8a) des ersten Streifens (6a). Die zweite Steckachse (4b) des zweiten Steckverbinders (2b) verläuft in einem vorbestimmten Abstand parallel zu der zweiten Längsachse (8b) des zweiten Steckverbinders (6b). Der zweite Steckverbinder (2b) weist eine Breite (B2) auf, welche der Breite (b2) des zweiten Streifens (6b) entspricht. Die Breite (B1) des ersten Steckverbinders (2a) ist größer als die Breite (B2) des zweiten Steckverbinders (2b) und die Breite (b1) des ersten Streifens (6a). Die Breite (b1) des ersten Streifens (6a) entspricht in diesem Fall der Breite (b2) des zweiten Streifens (6b), so dass die maximale Breite (b1, b2) der Streifen (6a, 6b) der kleinsten Breite (B2) eines Steckverbinders (2b, 2a) entspricht. Jeder der Streifen (6a, 6b) weist in der Nähe des jeweiligen Steckverbinders (2a, 2b) eine Beschriftung (12) auf.

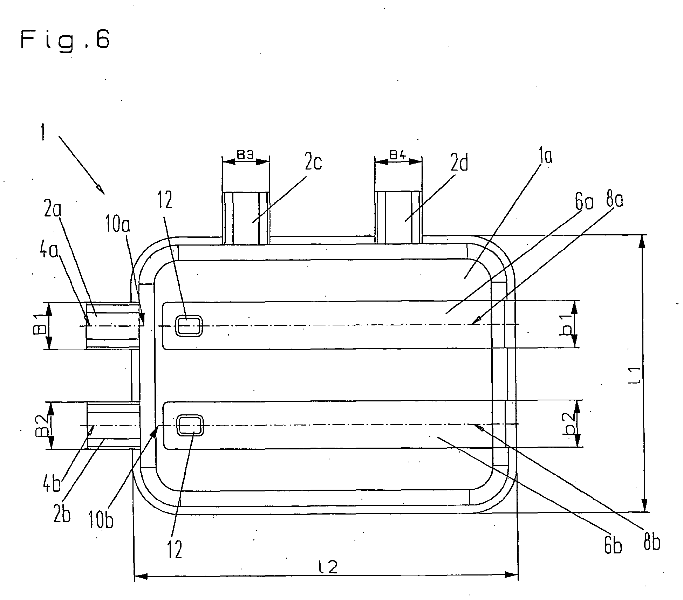

Die Figur 6 zeigt eine Draufsicht auf ein Gehäuse (1) mit einem ersten Steckverbinder (2a), der eine erste Steckachse (4a) aufweist, und einem zweiten Steckverbinder (2b), der eine zweite Steckachse (4b) aufweist sowie einem dritten Steckverbinder (2c) und einem vierten Steckverbinder (2d). Der erste Steckverbinder (2a) und der zweite Steckverbinder (2b) sind an der Gehäuseseite (1c) mit der ersten Seitenlänge (I1) angeordnet, welche kleiner ist als die zweite Seitenlänge (I2). Die erste Breite (B1) des ersten Steckverbinders (2a), die zweite Breite (B2) des zweiten Steckverbinders (2b), die dritte Breite (B3) des dritten Steckverbinders (2c) und die vierte Breite (B4) des vierten Steckverbinders (2d) weisen in diesem Ausführungsbeispiel den gleichen Wert auf. Ein erster Streifen (6a) mit einer ersten Längsachse (8a) ist dem ersten Steckverbinder (2a) bzw. der ersten Steckachse (4a) zugeordnet. Die erste Steckachse (4a) ist in einem vorbestimmten Abstand parallel zu der ersten Längsachse (8a) angeordnet, so dass diese beiden Achsen (4a, 8a) eine erste räumliche Ebene (10a) bilden. Die Breite (b1) des ersten Streifens (6a) entspricht der ersten Breite (B1) des ersten Steckverbinders (2a). Im Bereich des ersten Steckverbinders (2a) weist der erste Streifen (6a) eine Beschriftung (12) auf.

Der zweite Streifen (6b) mit der zweiten Längsachse (8b) ist dem zweiten Steckverbinder (2b) bzw. der zweiten Steckachse (4b) zugeordnet. Dabei ist die zweite Steckachse (4b) in einem vorbestimmten Abstand parallel zu der zweiten Längsachse (8b) angeordnet, so dass diese beiden Achsen (4b, 8b) eine zweite räumliche Ebene (10b) bilden. Die Breite (b2) des zweiten Streifens (6b) entspricht der zweiten Breite (B2) des zweiten Steckverbinders (2b). Der erste Streifen (6a) bzw. die erste Längsachse (8a) ist parallel zu dem zweiten Streifen (6b) bzw. der zweiten Steckachse (8b) angeordnet. Die erste Längsachse (8a) und die zweite Längsachse (8b) sind parallel zu der Gehäuseseite (1c) mit der zweiten Länge (I2) angeordnet, was es ermöglicht, einen möglichst langen und damit gut sichtbaren ersten oder zweiten Streifen (6a, 6b) auf der Gehäuseoberfläche (1a) des Gehäuses (1) anzuordnen.

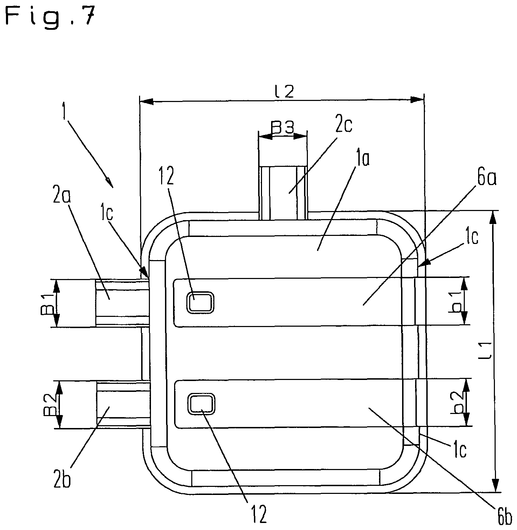

Die Figur 7 zeigt eine Draufsicht auf ein Gehäuse (1) mit einem ersten Steckverbinder (2a) und einem zweiten Steckverbinder (2b) und einem dritten Steckverbinder (2c). Der erste und der zweite Steckverbinder (2a, 2b) sind an der Gehäuseseite (1c) mit der ersten Seitenlänge (I1) angeordnet. Der dritte Steckverbinder (2c) ist an der Gehäuseseite mit der zweiten Seitenlänge (I2) angeordnet. Um in diesem Falle eine möglichst ausführliche und umfassende Beschriftung und Kennzeichnung der Steckverbinder (2a, 2b, 2c) zu erhalten, sind den Steckverbindern (2a, 2b) an der Gehäuseseite (1c) mit der höheren Anzahl angeordneter Steckverbinder (2a, 2b) die erfindungsgemäßen Streifen (6a, 6b) zugeordnet. Dem ersten Steckverbinder (2a) ist ein erster Streifen (6a) und dem zweiten Steckverbinder (2d) ist ein zweiter Streifen (6b) in bekannter Weise, wie in den vorherigen Figuren beschrieben, zugeordnet. Sowohl der erste Streifen (6a) als auch der zweite Streifen (6b) weisen im Bereich des ersten Steckverbinders (2a) bzw. des zweiten Steckverbinders (2b) eine Beschriftung (12) auf, welche einen Hinweis auf die Funktion des jeweiligen Steckverbinders (2a, 2b) ermöglicht.

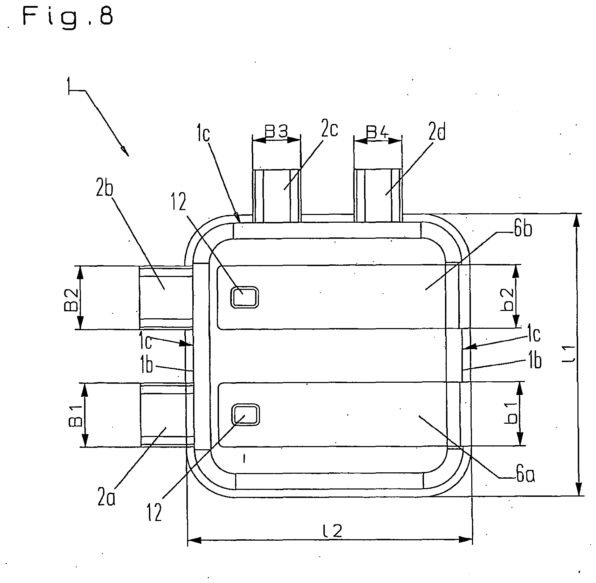

Die Figur 8 zeigt ein Gehäuse (1) mit einem ersten Steckverbinder (2a), einem zweiten Steckverbinder (2b), einem dritten Steckverbinder (2c) und einem vierten Steckverbinder (2d). Der erste Steckverbinder (2a) und der zweite Steckverbinder (2b) sind an der Gehäuseseite (1c) mit der ersten Seitenlänge (I1) angeordnet. Der dritte Steckverbinder (2c) und der vierte Steckverbinder (2d) sind an der Gehäuseseite (1c) mit der zweiten Seitenlänge (I2) angeordnet. Die erfindungsgemäßen ersten und zweiten Streifen (6a, 6b) sind aufgrund der gleichen Anzahl von Steckverbindern (2a, 2b, 2c, 2d) an jeder Gehäuseseite (1c) den Steckverbindern (2a, 2b) mit der größeren Breite (B1, B2) zugeordnet. Dies hat den Vorteil einer besseren Sichtbarkeit und Wiedererkennung. Dem ersten Steckverbinder (2a) ist, wie in den vorherigen Figuren beschrieben, ein erster Streifen (6a) zugeordnet. Dem zweiten Steckverbinder (2b) ist, wie in den vorherigen Figuren beschrieben, ein zweiter Streifen (6b) zugeordnet. Obwohl die erste Seitenlänge (I1) und die zweite Seitenlänge (I2) in diesem Ausführungsbeispiel identisch bzw. gleich sind, ist aufgrund der ersten Breite (B1) des ersten Steckverbinders (2a) und der zweiten Breite (B2) des zweiten Steckverbinders (2d) jeweils der erste Streifen (6a) bzw. der zweite Streifen (6b) zugeordnet. Die Breite (B1) des ersten Steckverbinders (2a) und die Breite (B2) des zweiten Steckverbinders (2b) sind in diesem Ausführungsbeispiel identisch und größer als die dritte Breite (B3) des dritten Steckverbinders (2c) und die vierte Breite (B4) des vierten Steckverbinders (2d). Der erste Streifen (6a) weist eine Breite (b1) auf, welche identisch bzw. gleich der ersten Breite (B1) des ersten Steckverbinders (2a) ist. Auch die Breite (b2) des zweiten Streifens (6b) ist identisch bzw. gleich der zweiten Breite (B2) des zweiten Steckverbinders (2b). Sowohl der erste Streifen (6a) als auch der zweite Streifen (6b) weisen im Bereich des ersten Steckverbinders (2a) bzw. des zweiten Steckverbinders (2b) eine Beschriftung (12) auf.

Das Gehäuse (1) in den Figuren 1 bis 8 kann als ein Gehäuse (1) einer Elektronikeinheit und/oder einer Pneumatikeinheit ausgebildet sein. Wenn das Gehäuse (1) für eine Elektronik ausgebildet ist, dann sind die entsprechenden Steckverbinder (2a, 2b, 2c, 2d) als elektronische oder elektrische Steckverbinder ausgebildet. Wenn das Gehäuse (1) für eine Pneumatikeinheit, wie z.B. einen ABS-Modulator, ausgebildet ist, dann sind die entsprechenden Steckverbinder (2a, 2b, 2c, 2d) als pneumatische Steckverbinder bzw. Anschlüsse zu verstehen und dementsprechend ausgebildet.

## Patentansprüche

1. Gehäuse (1) für eine Anschlusseinheit, welche als eine Elektronikeinheit oder Pneumatikeinheit ausgeführt ist, mit mindestens einem ersten Steckverbinder (2a) und einer ersten Steckachse (4a) des ersten Steckverbinders (2a),
wobei das Gehäuse (1) in oder an der Gehäuseoberfläche (1a) einen einstückig mit dem Gehäuse (1) verbundenen ersten Streifen (6a) aufweist, wobei der erste Streifen (6a) eine andere Oberflächenbeschaffenheit aufweist, als die Gehäuseoberfläche (1a) und/oder der erste Streifen (6a) gegenüber der Gehäuseoberfläche (1a) vertieft oder erhöht angeordnet ist, und wobei eine erste Längsachse (8a) des ersten Streifens (6a) in einer ersten räumlichen Ebene (10a) mit der ersten Steckachse (4a) des ersten Steckverbinders (2a) angeordnet ist, wobei der erste Streifen (6a) vom ersten Steckverbinder (2a) beginnend an der Gehäuseoberfläche (1a) angeordnet ist.

2. Gehäuse (1) für eine Anschlusseinheit nach Anspruch 1, **dadurch gekennzeichnet, dass** das Gehäuse (1) mindestens einen zweiten Steckverbinder (2b) mit einer zweiten Steckachse (4b) und einen zweiten Streifen (6b) aufweist, wobei eine zweite Längsachse (8b) des zweiten Streifens (6b) in einer zweiten räumlichen Ebene (10b) mit der zweiten Steckachse (4b) des zweiten Steckverbinders (2b) angeordnet ist.

3. Gehäuse (1) für eine Anschlusseinheit nach Anspruch 1 oder 2, **dadurch gekennzeichnet, dass** das Gehäuse (1) mindestens einen dritten Steckverbinder (2c) mit einer dritten Steckachse (4c) und einen dritten Streifen (6c) aufweist, wobei eine dritte Längsachse (8c) des dritten Streifens (6c) in einer dritten räumlichen Ebene (10c) mit der dritten Steckachse (4c) des dritten Steckverbinders (2c) angeordnet ist.

4. Gehäuse (1) für eine Anschlusseinheit nach Anspruch 1 bis 3, **dadurch gekennzeichnet, dass** der zweite und/oder dritte Streifen (6b, 6c) eine andere Oberflächenbeschaffenheit aufweist, als die Gehäuseoberfläche (1a).

5. Gehäuse (1) für eine Anschlusseinheit nach Anspruch 4, **dadurch gekennzeichnet, dass** der zweite und/oder dritte Streifen (6b, 6c) gegenüber der Gehäuseoberfläche (1a) vertieft, insbesondere um die Tiefe t, angeordnet ist.

6. Gehäuse (1) für eine Anschlusseinheit nach Anspruch 4 bis 5, **dadurch gekennzeichnet, dass** der zweite und/oder dritte Streifen (6b, 6c) gegenüber der Gehäuseoberfläche (1a) erhöht, insbesondere um die Höhe h, angeordnet ist.

7. Gehäuse (1) für eine Anschlusseinheit nach einem der vorherigen Ansprüche, **dadurch gekennzeichnet, dass** der erste, zweite und/oder dritte Streifen (6a, 6b, 6c) eine Beschriftung (12) aufweist.

8. Gehäuse (1) für eine Anschlusseinheit nach einem der vorherigen Ansprüche, **dadurch gekennzeichnet, dass** der erste, zweite und/oder dritte Streifen (6a, 6b, 6c) parallel zueinander angeordnet sind.

9. Gehäuse (1) für eine Anschlusseinheit nach einem der vorherigen Ansprüche, **dadurch gekennzeichnet, dass** der erste, zweite und/oder dritte Streifen (6a, 6b, 6c) senkrecht zu der ersten, zweiten und/oder dritten Steckachse (4a, 4b, 4c) angeordnet ist.

10. Gehäuse (1) für eine Anschlusseinheit nach einem der vorherigen Ansprüche, **dadurch gekennzeichnet, dass** der zweite und/oder dritte Streifen (6a, 6b, 6c) vom zweiten und/oder dritten Steckverbinder (2a, 2b, 2c) beginnend bis zu einer Körperkante (1b) der Gehäuseoberfläche (1a) angeordnet ist.

11. Gehäuse (1) für eine Anschlusseinheit nach einem der vorherigen Ansprüche, **dadurch gekennzeichnet, dass** die Breite (b1, b2, b3) des ersten, zweiten und/oder dritten Streifens (6a, 6b, 6c) maximal der Breite (B1, B2, B3) des ersten, zweiten und/oder dritten Steckverbinders (2a, 2b, 2c) entspricht.

12. Gehäuse (1) für eine Anschlusseinheit nach einem der vorherigen Ansprüche, **dadurch gekennzeichnet, dass** der erste, zweite und/oder dritte Streifen (6a, 6b, 6c) die gleiche Breite (b1, b2, b3) aufweisen.

13. Gehäuse (1) für eine Anschlusseinheit nach Anspruch 11 oder 12, **dadurch gekennzeichnet, dass** die Breite (b1, b2, b3) des ersten, zweiten und/oder dritten Streifens (6a, 6b, 6c) maximal der kleinsten Breite (B1, B2, B3) des ersten, zweiten und/oder dritten Steckverbinders (2a, 2b, 2c) entspricht.

14. Gehäuse (1) für eine Anschlusseinheit nach einem der vorherigen Ansprüche, **dadurch gekennzeichnet, dass** der erste, zweite und/oder dritte Streifen (6a, 6b, 6c) senkrecht zu der Gehäuseseite (1c) mit der höheren Anzahl von Steckverbindern (2a, 2b, 2c) angeordnet ist.

15. Gehäuse (1) für eine Anschlusseinheit nach einem der vorherigen Ansprüche, **dadurch gekennzeichnet, dass** der erste, zweite und/oder dritte Streifen (6a, 6b, 6c) senkrecht zu der Gehäuseseite (1c) mit der größeren Breite (B1, B2, B3) der ersten, zweiten und/oder dritten Steckverbinder (2a, 2b, 2c) angeordnet ist.

16. Gehäuse (1) für eine Anschlusseinheit nach einem der vorherigen Ansprüche, **dadurch gekennzeichnet, dass** der erste, zweite und/oder dritte Streifen (6a, 6b, 6c) parallel zu der längsten Gehäuseseite (1c) angeordnet ist.

17. Gehäuse (1) für eine Anschlusseinheit nach Anspruch 1, **dadurch gekennzeichnet, dass** der erste Streifen (2a) asymmetrisch auf dem Gehäuse (1) angeordnet ist.

18. Gehäuse (1) für eine Anschlusseinheit nach Anspruch 17, **dadurch gekennzeichnet, dass** der erste Streifen (2a) einen Abstand d von mindestens einer Körperkante (1b) der Gehäuseoberfläche (1a) aufweist.

19. Gehäuse (1) für eine Anschlusseinheit nach Anspruch 18, **dadurch gekennzeichnet, dass** der Abstand d der Breite (b1) des ersten Streifens (2a) entspricht.

## Claims

1. Housing (1) for a connecting unit, which is embodied as an electronic unit or pneumatic unit, having at least one first plug connector (2a) and one first plug axis (4a) of the first plug connector (2a), wherein the housing (1) has a first strip (6a) connected in one piece to the housing (1) in or on the housing surface (1a), the first strip (6a) having a different surface finish from the housing surface (1a) and/or the first strip (6a) being disposed in a manner recessed or raised relative to the housing surface (1a), and a first longitudinal axis (8a) of the first strip (6a) being disposed in a first spatial plane (10a) with the first plug axis (4a) of the first plug connector (2a), the first strip (6a) being disposed so as to start from the first plug connector (2a) on the housing surface (1a).

2. Housing (1) for a connecting unit according to Claim 1, **characterized in that** the housing (1) has at least one second plug connector (2b) with a second plug axis (4b) and a second strip (6b), a second longitudinal axis (8b) of the second strip (6b) being disposed in a second spatial plane (10b) with the second plug axis (4b) of the second plug connector (2b) .

3. Housing (1) for a connecting unit according to Claim 1 or 2, **characterized in that** the housing (1) has at least one third plug connector (2c) with a third plug axis (4c) and a third strip (6c), a third longitudinal axis (8c) of the third strip (6c) being disposed in a third spatial plane (10c) with the third plug axis (4c) of the third plug connector (2c).

4. Housing (1) for a connecting unit according to Claims 1 to 3, **characterized in that** the second and/or third strip (6b, 6c) has a different surface finish from the housing surface (1a).

5. Housing (1) for a connecting unit according to Claim 4, **characterized in that** the second and/or third strip (6b, 6c) is disposed in a manner recessed relative to the housing surface (1a), in particular by the depth t.

6. Housing (1) for a connecting unit according to Claims 4 to 5, **characterized in that** the second and/or third strip (6b, 6c) is disposed in a manner raised relative to the housing surface (1a), in particular by the height h.

7. Housing (1) for a connecting unit according to one of the preceding claims, **characterized in that** the first, second and/or third strip (6a, 6b, 6c) has a legend (12).

8. Housing (1) for a connecting unit according to one of the preceding claims, **characterized in that** the first, second and/or third strip (6a, 6b, 6c) are disposed parallel to one another.

9. Housing (1) for a connecting unit according to one of the preceding claims, **characterized in that** the first, second and/or third strip (6a, 6b, 6c) is disposed perpendicularly to the first, second and/or third plug axis (4a, 4b, 4c).

10. Housing (1) for a connecting unit according to one of the preceding claims, **characterized in that** the second and/or third strip (6a, 6b, 6c) is disposed so as to start from the second and/or third plug connector (2a, 2b, 2c) and to extend as far as an outline edge (1b) of the housing surface (1a).

11. Housing (1) for a connecting unit according to one of the preceding claims, **characterized in that** the width (b1, b2, b3) of the first, second and/or third strip (6a, 6b, 6c) corresponds at the maximum to the width (B1, B2, B3) of the first, second and/or third plug connector (2a, 2b, 2c).

12. Housing (1) for a connecting unit according to one of the preceding claims, **characterized in that** the first, second and/or third strip (6a, 6b, 6c) are of the same width (b1, b2, b3).

13. Housing (1) for a connecting unit according to Claim 11 or 12, **characterized in that** the width (b1, b2, b3) of the first, second and/or third strip (6a, 6b, 6c) corresponds at the maximum to the minimum width (B1, B2, B3) of the first, second and/or third plug connector (2a, 2b, 2c).

14. Housing (1) for a connecting unit according to one of the preceding claims, **characterized in that** the first, second and/or third strip (6a, 6b, 6c) is disposed perpendicularly to the housing side (1c) with the higher number of plug connectors (2a, 2b, 2c).

15. Housing (1) for a connecting unit according to one of the preceding claims, **characterized in that** the first, second and/or third strip (6a, 6b, 6c) is disposed perpendicularly to the housing side (1c) with the greater width (B1, B2, B3) of the first, second and/or third plug connectors (2a, 2b, 2c).

16. Housing (1) for a connecting unit according to one of the preceding claims, **characterized in that** the first, second and/or third strip (6a, 6b, 6c) is disposed parallel to the longest housing side (1c).

17. Housing (1) for a connecting unit according to Claim 1, **characterized in that** the first strip (2a) is disposed asymmetrically on the housing (1).

18. Housing (1) for a connecting unit according to Claim 17, **characterized in that** the first strip (2a) is at a distance d from at least one outline edge (1b) of the housing surface (1a).

19. Housing (1) for a connecting unit according to Claim 18, **characterized in that** the distance d corresponds to the width (b1) of the first strip (2a).

## Revendications

1. Boîtier (1) pour une unité de raccordement, qui est réalisée sous la forme d'une unité électronique ou pneumatique, comportant au moins un premier connecteur (2a) et un premier axe d'enfichage (4a) du premier connecteur (2a),
dans lequel le boîtier (1) comporte, dans ou sur la surface de boîtier (1a), une première bande (6a) reliée de manière solidaire au boîtier (1), dans lequel la première bande (6a) présente un état de surface différent de celui de la surface de boîtier (1a) et/ou la première bande (6a) est disposée en retrait ou en relief par rapport à la surface de boîtier (1a), et dans lequel un premier axe longitudinal (8a) de la première bande (6a) est disposé dans un premier plan spatial (10a) formé avec le premier axe d'enfichage (4a) du premier connecteur (2a), dans lequel la première bande (6a) est disposée en partant du premier connecteur (2a) vers la surface de boîtier (1a).

2. Boîtier (1) pour une unité de raccordement selon la revendication 1, **caractérisé en ce que** le boîtier (1) comporte au moins un deuxième connecteur (2b) présentant un deuxième axe d'enfichage (4b) et une deuxième bande (6b), dans lequel un deuxième axe longitudinal (8b) de la deuxième bande (6b) est disposé dans un deuxième plan spatial (10b) formé avec le deuxième axe d'enfichage (4b) du deuxième connecteur (2b) .

3. Boîtier (1) pour une unité de raccordement selon la revendication 1 ou 2, **caractérisé en ce que** le boîtier (1) comporte au moins un troisième connecteur (2c) présentant un troisième axe d'enfichage (4c) et une troisième bande (6c), dans lequel un troisième axe longitudinal (8c) de la troisième bande (6c) est disposé dans un troisième plan spatial (10e) formé avec le troisième axe d'enfichage (4c) du troisième connecteur (2c).

4. Boîtier (1) pour une unité de raccordement selon les revendications 1 à 3, **caractérisé en ce que** les deuxième et/ou troisième bandes (6b, 6c) présentent un état de surface différent de celui du boîtier (1a).

5. Boîtier (1) pour une unité de raccordement selon la revendication 4, **caractérisé en ce que** les deuxième et/ou troisième bandes (6b, 6c) sont disposées en retrait par rapport à la surface de boîtier (1a), en particulier à une profondeur t.

6. Boîtier (1) pour une unité de raccordement selon les revendications 4 à 5, **caractérisé en ce que** les deuxième et/ou troisième bandes (6b, 6c) sont disposées en relief par rapport à la surface du boîtier (1a), en particulier à une hauteur h.

7. Boîtier (1) pour une unité de raccordement selon l'une des revendications précédentes, **caractérisé en ce que** les première, deuxième et/ou troisième bandes (6a, 6b, 6c) présentent une inscription (12).

8. Boîtier (1) pour une unité de raccordement selon l'une des revendications précédentes, **caractérisé en ce que** les première, deuxième et/ou troisième bandes (6a, 6b, 6c) sont disposées parallèlement les unes aux autres.

9. Boîtier (1) pour une unité de raccordement selon l'une des revendications précédentes, **caractérisé en ce que** les première, deuxième et/ou troisième bandes (6a, 6b, 6c) sont disposées perpendiculairement aux premier, deuxième et/ou troisième axes d'enfichage (4a, 4b, 4c).

10. Boîtier (1) pour une unité de raccordement selon l'une des revendications précédentes, **caractérisé en ce que** les deuxième et/ou troisième bandes (6a, 6b, 6c) sont disposées entre les deuxième et/ou troisième connecteurs (2a, 2b, 2c) et une arête de corps (1b) de la surface de boîtier (1a).

11. Boîtier (1) pour une unité de raccordement selon l'une des revendications précédentes, **caractérisé en ce que** la largeur (b1, b2, b3) des première, deuxième et/ou troisième bandes (6a, 6b, 6c) correspond au plus à la largeur (B1, B2, B3) des premier, deuxième et/ou troisième connecteurs (2a, 2b, 2c).

12. Boîtier (1) pour une unité de raccordement selon l'une des revendications précédentes, **caractérisé en ce que** les première, deuxième et/ou troisième bandes (6a, 6b, 6c) présentent la même largeur (b1, b2, b3).

13. Boîtier (1) pour une unité de raccordement selon la revendication 11 ou 12, **caractérisé en ce que** la largeur (b1, b2, b3) des première, deuxième et/ou troisième bandes (6a, 6b, 6c) correspond au plus à la plus petite largeur (B1, B2, B3) des premier, deuxième et/ou troisième connecteurs (2a, 2b, 2c).

14. Boîtier (1) pour une unité de raccordement selon l'une des revendications précédentes, **caractérisé en ce que** les première, deuxième et/ou troisième bandes (6a, 6b, 6c) sont disposée perpendiculairement à la face de boîtier (1c) qui présente le plus grand nombre de connecteurs (2a, 2b, 2c).

15. Boîtier (1) pour une unité de raccordement selon l'une des revendications précédentes, **caractérisé en ce que** les première, deuxième et/ou troisième bandes (6a, 6b, 6c) sont disposées perpendiculairement à la face de boîtier (1c) qui présente la plus grande largeur (B1, B2, B3) des premier, deuxième et/ou troisième connecteurs (2a, 2b, 2c).

16. Boîtier (1) pour une unité de raccordement selon l'une des revendications précédentes, **caractérisé en ce que** les première, deuxième et/ou troisième bandes (6a, 6b, 6c) sont disposée parallèlement à la face de boîtier (1c) la plus longue.

17. Boîtier (1) pour une unité de raccordement selon la revendication 1, **caractérisé en ce que** la première bande (2a) est disposée de manière asymétrique sur le boîtier (1).

18. Boîtier (1) pour une unité de raccordement selon la revendication 17, **caractérisé en ce que** la première bande (2a) présente une distance d par rapport à au moins une arête de corps (1b) de la surface de boîtier (1a).

19. Boîtier (1) pour une unité de raccordement selon la revendication 18, **caractérisé en ce que** la distance d correspond à la largeur (b1) de la première bande (2a).
